# EUROPEAN PATENT APPLICATION

(11) **EP 4 668 340 A1**
(43) Date of publication of application: **24.12.2025**
(21) Application number: 24182552.0
(22) Date of filing: 17.06.2024
(51) Int. Cl.: H01L 29/808, H01L 29/10, H01L 29/165

(54) **VERTICAL JUNCTION FIELD EFFECT TRANSISTOR INCLUDING A SILICON LAYER IN A TRENCH STRUCTURE**

(71) Applicant: Infineon Technologies Austria AG, 9500 Villach (AT)
(72) Inventor: WEBER, Hans, 9500 Villach (AT); FISCHER, Björn, 81547 München (DE); NARAHASCHI, Hiroshi, 9500 Villach (AT); FISCHER, Petra Erika, 9241 Wernberg (AT); KAMMERLANDER, David, 9500 Villach (AT); FORSTER, Magdalena, 9551 Bodensdorf (AT); HOFER, Heimo, 9551 Steindorf (AT); WIESER, Robert, 9241 Wernberg (AT); TREU, Michael Franz, 9500 Villach (AT)
(74) Representative: Müller Hoffmann & Partner

(57) **Abstract**

A vertical junction field effect transistor, VJFET (100), is proposed. The VJFET includes a trench structure (102) laterally arranged between mesa regions (1041, 1042) along a first lateral direction (x1). The trench structure (102) extends into a semiconductor body (106) from a first surface (108) of the semiconductor body (106). Each of the mesa regions (1041, 1042) includes a mesa channel region (110) of a first conductivity type. The VJFET (100) further includes a gate region (112) of a second conductivity type. The gate region (112) adjoins at least part of opposite sidewalls (1021, 1022) of the trench structure (102) and to a bottom side (1023) of the trench structure (102). The trench structure (102) includes a silicon layer (114) adjoining the gate region (112) at the bottom side (1023) of the trench structure (102). A first thickness (t1) of the gate region at the bottom side (1023) of the trench structure (102) is larger than a second thickness (t2) of the gate region (112) at each of the opposite sidewalls (1021, 1022) of the trench structure.

## Description

### TECHNICAL FIELD

The present disclosure is related to a semiconductor device, in particular to a vertical junction field effect transistor, VJFET, including a silicon layer in a trench structure.

### BACKGROUND

Technology development of new generations of semiconductor devices, e.g. junction field effect transistors (JFETs), aims at improving electric device characteristics and reducing costs by shrinking device geometries. Although costs may be reduced by shrinking device geometries, a variety of tradeoffs and challenges have to be met when increasing device functionalities per unit area. For example, a trade-off between area-specific on-state resistance, RₒₙxA, and reliability requirements influenced by, for example, electric breakdown capability, requires design optimization.

Thus, there is a need for an improved junction field effect transistor.

### SUMMARY

An example of the present disclosure relates to a vertical junction field effect transistor, VJFET. The VJFET includes a trench structure laterally arranged between mesa regions along a first lateral direction. The trench structure extends into a semiconductor body from a first surface of the semiconductor body. Each of the mesa regions includes a mesa channel region of a first conductivity type. The VJFET further includes a gate region of a second conductivity type. The gate region adjoins at least part of opposite sidewalls of the trench structure and a bottom side of the trench structure. The trench structure includes a silicon layer adjoining the gate region at the bottom side of the trench structure. A first thickness of the gate region at the bottom side of the trench structure is larger than a second thickness of the gate region at each of the opposite sidewalls of the trench structure.

Another example of the present disclosure relates to a method of manufacturing a VJFET. The method includes forming a trench structure laterally arranged between mesa regions along a first lateral direction. The trench structure extends into a semiconductor body from a first surface of the semiconductor body. Each of the mesa regions includes a mesa channel region of a first conductivity type. The method further includes forming a gate region of a second conductivity type. The gate region adjoins to at least part of opposite sidewalls of the trench structure and to a bottom side of the trench structure. The method further includes forming a silicon layer adjoining the gate region at the bottom side of the trench structure. A first thickness of the gate region at the bottom side of the trench structure may be is larger than a second thickness of the gate region at each of the opposite sidewalls of the trench structure.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of VJFETs and together with the description serve to explain principles of the examples. Further examples are described in the following detailed description and the claims.
Fig. 1 is an exemplary process illustration of manufacturing a VJFET.
Fig. 2 is a schematic cross-sectional view for illustrating a configuration example of a VJFET including a gate region and a silicon layer in a trench structure.
Fig. 3 is a schematic cross-sectional view for illustrating an exemplary and more detailed view of the gate region of the VJFET of Fig. 2.
Fig. 4 is a schematic graph illustrating a profile of doping concentration of the gate region along the vertical direction y.
Figs. 5 and 6 are schematic cross-sectional views for illustrating further configuration examples of VJFETs.
Figs. 7A to 7E are schematic cross-sectional views for illustrating exemplary process features of forming the trench structure or part thereof.
Fig. 8 is a schematic cross-sectional view for illustrating an exemplary process feature.

### DETAILED DESCRIPTION

In the following detailed description, reference is made to the accompanying drawings, which form a part hereof and in which are shown by way of illustrations specific examples of VJFETs. It is to be understood that other examples may be utilized and structural or logical changes may be made without departing from the scope of the present disclosure. For example, features illustrated or described for one example can be used in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact is a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of a vertical junction field effect transistor, VJFET, includes a trench structure laterally arranged between mesa regions along a first lateral direction. The trench structure extends into a semiconductor body from a first surface of the semiconductor body. Each of the mesa regions includes a mesa channel region of a first conductivity type. The VJFET further includes a gate region of a second conductivity type. The gate region adjoins at least part of opposite sidewalls of the trench structure and a bottom side of the trench structure. The trench structure may further include a silicon layer adjoining the gate region at the bottom side of the trench structure. A first thickness of the gate region at the bottom side of the trench structure may be larger than a second thickness of the gate region at each of the opposite sidewalls of the trench structure.

The first lateral direction may be a transverse direction of the trench structure that may run perpendicular to a longitudinal direction of the trench structure. For example, a width of the trench structure may be measured along the first lateral direction, for example.

The VJFET may be part of an integrated circuit or may define a discrete semiconductor device or a semiconductor module, for example. For example, the VJFET may be a trenched and implanted vertical-channel JFET, TI-VJFET. In a vertical-channel JFET, a load current flow is between a first load electrode over the first surface of the semiconductor body and a second load electrode over a second surface opposite to the first surface along the vertical direction. In the vertical-channel JFET, a load current may flow along the vertical direction perpendicular to the first and/or second surface. The VJFET may be used in applications related to power transmission and distribution, automotive and transport, renewable energy, consumer electronics, and other industrial applications, for example.

The first surface may be a front surface or a top surface of the semiconductor body, and the second surface may be a back surface or a rear surface of the semiconductor body, for example. For example, the semiconductor body may be attached to a lead frame via the second surface, for example. Over the first surface of the semiconductor body, bond pads may be arranged and bond wires may be bonded on the bond pads, for example.

The semiconductor body may include or consist of a semiconductor material from the group IV elemental semiconductors, IV-IV compound semiconductor material, III-V compound semiconductor material, or II-VI compound semiconductor material. Examples of semiconductor materials from the group IV elemental semiconductors include, inter alia, silicon (Si) and germanium (Ge). Examples of IV-IV compound semiconductor materials include, inter alia, silicon carbide (SiC) and silicon germanium (SiGe). Examples of III-V compound semiconductor material include, inter alia, gallium arsenide (GaAs), gallium nitride (GaN), gallium phosphide (GaP), indium phosphide (InP), indium gallium nitride (InGaN) and indium gallium arsenide (InGaAs). Examples of II-VI compound semiconductor materials include, inter alia, cadmium telluride (CdTe), mercury-cadmium-telluride (CdHgTe), and cadmium magnesium telluride (CdMgTe). For example, the semiconductor body may a crystalline SiC semiconductor substrate having none, one or more SiC layers formed thereon. For example, the silicon carbide crystal may have a hexagonal polytype, e.g., 4H or 6H. The silicon carbide semiconductor body may be homogeneously doped or may include differently doped SiC layer portions. The silicon carbide semiconductor body may include one or more layers from another material with a melting point close to or higher than crystalline silicon carbide. For example, the layers from another material may be embedded in the crystalline silicon carbide substrate. The silicon carbide semiconductor substrate may have two essentially parallel main surfaces of the same shape and size and a lateral surface area connecting the edges of the two main surfaces.

The VJFET may be configured to conduct currents of more than 1A or more than 10 A or even more than 100 A. For example, the VJFET may be designed as a transistor cell array of a plurality of transistor cells having a same layout. The transistor cell array may be a 1-dimensional or a 2-dimensional regular arrangement of the plurality of transistor cells. For example, the plurality of transistor cells of the transistor cell array may be electrically connected in parallel. For example, source regions of the plurality of transistor cells of the VJFET transistor cell array may be electrically connected together. Likewise, drain regions of the plurality of transistor cells of the VJFET transistor cell array may be electrically connected together. For example, gate regions of the plurality of transistor cells of the VJFET transistor cell array may be electrically connected together. A transistor cell of the transistor cell array or a part thereof, e.g. the gate region, may be designed in the shape of a stripe, a polygon, a circle or an oval, for example.

A number of transistor cells of the transistor cell array may depend on the maximum load current, for example. For example, a number of transistor cells of the transistor cell array may be larger than 100, or larger than 1000, or even larger than 10000, for example. The VJFET may be further configured to block voltages between the load electrodes, e.g. between drain and source of the VJFET, of more than 60V, 100V, 400 V, 650V, 1.2kV, 1.7kV, 3.3kV, 4.5kV, 5.5kV, 6kV, 6.5kV, 10kV. The blocking voltage may correspond to a voltage class specified in a datasheet of the VJFET, for example. The blocking voltage of the VJFET may be adjusted by an impurity concentration and/or a vertical extension of a drift region in the semiconductor body. A doping concentration of the drift region may gradually or in steps increase or decrease with increasing distance to the first surface at least in portions of its vertical extension. According to other examples the impurity concentration in the drift region may be approximately uniform. For VJFETs based on silicon, a mean impurity concentration in the drift region may be between 2 × 10¹² cm⁻³ and 1 × 10¹⁷ cm⁻³, for example in a range from 5 × 10¹² cm⁻³ to 1 × 10¹⁵ cm⁻³ or to 2 × 10¹⁵ cm⁻³. In some cases, the mean impurity concentration in the drift region for JFETs based on silicon may be in a range from 1 × 10¹⁵ cm⁻³ to 1 × 10¹⁷ cm⁻³. In the case of a JFET based on SiC, a mean impurity concentration in the drift region may be between 5 × 10¹⁴ cm⁻³ and 1 × 10¹⁷ cm⁻³, for example in a range from 1 × 10¹⁵ cm⁻³ to 2 × 10¹⁶ cm⁻³. A vertical extension of the drift region may depend on voltage blocking requirements, e.g. a specified voltage class, of the VJFET. When operating the VJFET in voltage blocking mode, a space charge region may vertically extend partly or totally through the drift region depending on the blocking voltage applied to the VJFET.

A source electrode of the VJFET may be arranged over the first surface of the semiconductor body and may be part of a wiring area over the semiconductor body. The wiring area may include one or more than one, e.g. two, three, four or even more wiring levels. Each wiring level may be formed by a single one or a stack of conductive layers, e.g. metal layer(s). The wiring levels may be lithographically patterned, for example. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another. The source electrode may be formed by one or more elements of the wiring area over the first surface. Likewise, a drain electrode may be formed by one or more elements of a wiring area over the second surface of the semiconductor body, for example.

For example, each of the mesa regions may be laterally confined by two adjacent trench structures. In each of the plurality of mesa regions, the mesa channel region of the first conductivity type may be formed. A doping concentration in the mesa channel region may be set by in-situ doping with dopants of the first conductivity type when forming a semiconductor layer on a substrate, e.g. by a layer deposition technique. The doping concentration in the mesa channel region may, in addition or as an alternative, be set by ion implantation of dopants of the first conductivity type through a sidewall of trenches of the trench structures, e.g. by one or more tilted ion implantation processes. The one or more tilted ion implantation processes may introduce more dopants into a central third part of the mesa region than in each of the two adjacent outer third parts.

For example, dopants in a semiconductor body comprising SiC may include Al, B, Be, Ga, or any combination thereof for p-type doping, an N, P, or any combination thereof for n-type doping. For example, dopants in a semiconductor body comprising Si may include Al, B, Ga, In, or any combination thereof for p-type doping, an P, As, Sb, hydrogen-related donors, or any combination thereof for n-type doping.

The width of the trench structure may be defined by a lateral extent of the trench structure at the first surface. For example, the width of the trench structure may correspond to a lateral distance between top sides of two adjacent mesa regions. For example, the width of the trench structure may be constant in an active transistor area of the VJFET. The active transistor area may be defined by an area where a load current enters the semiconductor body through the first surface, e.g. front surface. For example, the active transistor or active VJFET area may be defined by an area where source contacts plugs are placed. An edge termination area may laterally separate the active VJFET area and a field-free area and may completely surround the active VJFET area laterally. In a blocking mode or in a reverse biased mode of the VJFET, the blocking voltage between the active VJFET area and the field-free area laterally drops across the termination structure. The edge termination area may have a higher or a slightly lower voltage blocking capability than the active VJFET area. The edge termination area may include an edge termination structure, e.g. a junction termination extension (JTE) with or without a variation of lateral doping (VLD), one or more laterally separated guard rings, or any combination thereof.

The silicon layer adjoining the gate region at the bottom side of the trench structure may be based on any allotrope of silicon. For example, the silicon layer may be an amorphous silicon layer. The silicon layer may also be a crystalline silicon layer, e.g. a single-crystalline silicon layer, or a polycrystalline silicon layer, or a nanocrystalline silicon layer, or a microcrystalline silicon layer. For example, the silicon layer may be a re-crystallized silicon layer, e.g. a silicon layer that re-crystallized from an amorphous silicon layer by the thermal budget applied to the amorphous silicon layer during processing of the VJFET. For example, a thickness of the silicon layer may be smaller than a width of the trench structure. The silicon layer may cover or line a bottom side of the trench structure. The silicon layer, may, in addition, line a part of opposite sidewalls of the trench structure. For example the silicon layer may line or cover a lower part of the opposite sidewalls of the trench structure in addition to the bottom side. In some examples, the silicon layer lines or covers a predominant part of the opposite sidewalls or, with respect to a cross-sectional view of a predetermined position along the longitudinal direction of the trench structure, a total sidewall area of the opposite sidewalls of the trench structure. An inner part of the trench structure may include conductive and/or dielectric materials.

The gate region and the first thickness of the gate region at the bottom side of the trench structure may be adjusted by process parameters such as, for example, ion implantation energy of dopants of the gate region and/or thermal processing budget. the first thickness of the gate region at the bottom side of the trench structure may be adjusted by process parameters such as, for example, ion implantation energy of dopants of the gate region and/or thermal processing budget.

The silicon layer in the trench structure adjoining the gate region at the bottom side of the trench structure in combination with the thickness relation of the gate region at the bottom side and sidewalls of the trench structures enables a beneficial electric coupling between the gate region and the gate contact in the trench structure without a direct metal contact on the gate region which may be undesirable in view of reliability requirements. Although a contact at the bottom side of the trench structure may not be an ohmic contact, the electric coupling, e.g. supported by generation centers due to crystal defects in the semiconductor body close to the junction, may counteract an electric de-coupling between the gate region in the semiconductor body and the gate contact in the trench structure.

For example, the VJFET may include a junction between the gate region and the silicon layer at the bottom side of the trench structure. The junction may be a rectifying heterojunction, e.g. a rectifying Si/SiC heterojunction. The rectifying heterojunction may behave like a Schottky contact of a Schottky diode, wherein the silicon layer may be a degenerate semiconductor having such a high level of doping that the material has metal-like behavior. Crystal defects in the semiconductor body close to the junction may lead to a leakage current that enables an electric coupling between the gate region and the gate contact in the trench structure.

For example, a maximum doping concentration of the silicon layer may have a value in a range from 10¹⁶ cm⁻³ to 10²² cm⁻³, or from 10¹⁸ cm⁻³ to 10²² cm⁻³.

For example, the first thickness of the gate region at a center of the bottom side of the trench structure may be at least 50 % larger, or more than 75 % larger, or even more than 100 % larger than the second thickness of the gate region at a vertical reference level defined by a center of a vertical extension of the silicon layer. This may allow for more independently improving functional purposes at different locations of the gate region. For example, electric contact properties and/or voltage blocking capabilities by the gate region at the bottom side of the trench structure and channel properties by the gate region at the sidewalls of the trench may be more independently improved.

For example, a maximum doping concentration of a vertical doping concentration profile of the gate region at the lateral center of the bottom side of the trench structure may be from one to three orders of magnitude larger than a maximum doping concentration of a lateral doping concentration profile of the gate region at the vertical reference level.

For example, the gate region may be formed by at least three overlapping gate sub-regions, a first gate sub-region adjoining at least part of the opposite sidewalls of the trench structure, a second gate sub-region adjoining the bottom side of the trench structure, and a third gate sub-region adjoining a bottom side of the second gate sub-region. A vertical doping concentration profile defining the second gate sub-region and a vertical doping concentration profile defining the third gate sub-region may partly overlap.

For example, a first vertical distance from a bottom side of the third gate sub-region to the bottom side of the trench structure may be by a factor ranging from 2 to 20, or from 2 to 10, or from 2 to 5 larger than a second vertical distance from a bottom side of the second gate region to the bottom side of the trench structure. This may allow for more independently improving functional purposes at different locations of the gate region. For example, electric contact properties and voltage blocking capabilities by the gate region at the bottom side of the trench structure may be more independently improved.

For example, a maximum doping concentration of a vertical doping concentration profile of the second gate sub-region at the center of the bottom side of the trench structure may be from one to three orders of magnitude larger than a maximum doping concentration of a vertical doping concentration profile of the third gate sub-region at the center of the bottom side of the trench structure.

For example, a bottom side of the trench structure has a third vertical distance to the first surface. A top side of the silicon layer has a fourth vertical distance to the first surface. The fourth vertical distance may have a value in a range from 20 % to 99 %, or from 20 % to 80 %, or from 20 % to 60 % of the third vertical distance.

For example, the trench structure may further include a dielectric layer over the silicon layer. The dielectric layer may extend, along a vertical direction, from below the first surface toward, or up to or over the first surface. The dielectric layer may be formed as a dielectric plug, for example. The dielectric layer may be or may include an insulating material such as an oxide, e.g., SiO₂, a nitride, e.g., Si₃N₄, a high-k dielectric, or a low-k dielectric, or any combination thereof. For example, the dielectric structure may be formed as a disposed oxide, e.g. TEOS.

For example, the trench structure may further include at least one metal layer arranged between the dielectric layer and the silicon layer. The metal layer may be formed by a single layer or a stack of sub-layers. For example, Ti, or TiN, or Mo, or Nb, or Ta, or any combination thereof, e.g. Ti/TiN, may be used, e.g. as a barrier layer. In addition, another metal material such as, for example, W, or Al, may be formed on the barrier layer or directly on the silicon layer for improving transverse conductivity in the trench structure, for example.

For example, the silicon layer may line or cover a bottom side of the trench structure. The silicon layer may further line or cover at least part of the opposite sidewalls of the trench structure. The parts of the silicon layer lining or covering the opposite sidewalls may turn into the part of the silicon layer lining or covering the bottom side of the trench structure, for example. A thickness of the silicon layer may be smaller than 30 %, or smaller than 20 % of a width of the trench structure at the first surface.

For example, a pn junction between the gate region and the mesa channel region may adjoin the trench structure at a smaller vertical distance to the first surface than the third vertical distance.

Details with respect to structure, or function, or technical benefit of features described above with respect to a VJFET likewise apply to the exemplary methods described further below. Processing the semiconductor body may comprise one or more optional additional features corresponding to one or more aspects mentioned in connection with the proposed concept or one or more examples described above or below.

Some of the above and below examples are described in connection with a silicon carbide substrate. Alternatively, another wide band gap semiconductor substrate, e.g. a wide band gap wafer, may be processed, e.g. comprising a wide band gap semiconductor material different from silicon carbide. The wide band gap semiconductor wafer may have a band gap larger than the band gap of silicon (1.12 eV). For example, the wide band gap semiconductor wafer may be a gallium arsenide (GaAs) wafer. In some examples, the semiconductor body may be based on a silicon substrate.

In some of the illustrated examples, n-channel VJFETs are illustrated. However, the examples described herein may also be applied to p-channel devices, e.g. p-channel VJFETs.

The description and drawings merely illustrate the principles of the disclosure. Furthermore, all examples recited herein are principally intended expressly to be only for illustrative purpose to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, - processes, -operations or-steps, respectively. Such sub acts may be included and part of the disclosure of this single act unless explicitly excluded.

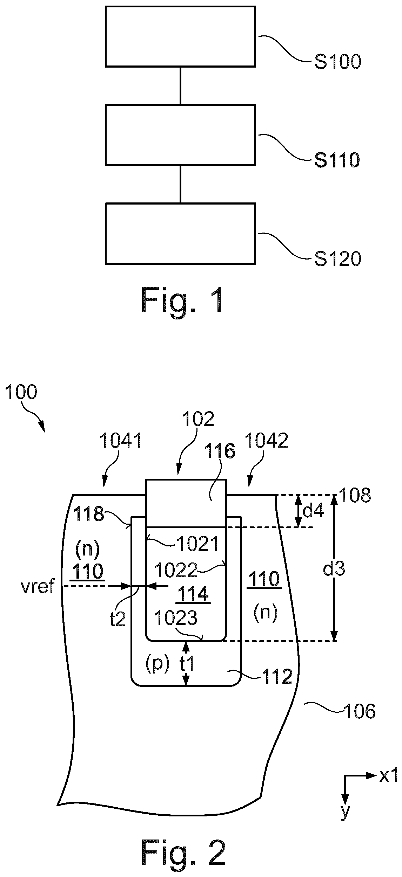

An example of a method of manufacturing a semiconductor device is illustrated by referring to the flowchart of Fig. 1.

Process feature S100 includes forming a trench structure laterally arranged between mesa regions along a first lateral direction. The trench structure extends into a semiconductor body from a first surface of the semiconductor body. Each of the mesa regions includes a mesa channel region of a first conductivity type.

Process feature S110 includes forming a gate region of a second conductivity type. The gate region adjoins at least part of opposite sidewalls of the trench structure and a bottom side of the trench structure.

Process feature S120 includes forming a silicon layer adjoining the gate region at the bottom side of the trench structure. A first thickness of the gate region at the bottom side of the trench structure is larger than a second thickness of the gate region at each of the opposite sidewalls of the trench structure.

A doping concentration profile in the mesa channel region may be set by in-situ doping with dopants of the first conductivity type when forming a semiconductor layer on a substrate, e.g. by a layer deposition technique. The doping concentration in the mesa channel region may, in addition or as an alternative, be set by ion implantation of dopants of the first conductivity type through a sidewall of trenches of the trench structures, e.g. by one or more tilted ion implantation processes. The one or more tilted ion implantation processes may introduce more dopants into a central part of the mesa region than in each of the two adjacent outer parts. Each of the parts, i.e. central part and outer parts, may have a same lateral extent.

For example, dopants in a semiconductor body comprising SiC may include Al, B, Be, Ga, or any combination thereof for p-type doping, an N, P, or any combination thereof for n-type doping. For example, dopants in a semiconductor body comprising Si may include Al, B, Ga, In, or any combination thereof for p-type doping, and P, As, Sb, hydrogen-related donors, or any combination thereof for n-type doping.

For example, the gate region may be formed by at least three overlapping gate sub-regions. A first gate sub-region may adjoin at least part of the opposite sidewalls of the trench structure. A second gate sub-region may adjoin the bottom side of the trench structure. A third gate sub-region may adjoin a bottom side of the second gate sub-region. Forming the first gate sub-region may include at least one tilted ion implantation process of dopants through a sidewall of a trench of the trench structure. Forming the second gate sub-region may include at least one ion implantation process of dopants through a bottom side of the trench of the trench structure, e.g. by a non-tilted or slightly tilted ion implantation process. A tilt angle of the slightly tilted ion implantation process may correspond to a tilt angle of sidewalls of the trench structure, for example. Forming the third gate sub-region may include at least one ion implantation process of dopants through the bottom side of the trench of the trench structure, e.g. by a non-tilted or slightly tilted ion implantation process. A tilt angle of the slightly tilted ion implantation process may correspond to a tilt angle of sidewalls of the trench structure, for example.

For example, an ion implantation dose of the dopants of the second gate sub-region may have a value in a range from 5 × 10¹⁴ cm⁻² to 5 × 10¹⁶ cm⁻², or in a range from 1 × 10¹⁵ cm⁻² to 1 × 10¹⁶ cm⁻².

A configuration example of a VJFET 100 is illustrated in the schematic cross-sectional view of Fig. 2.

The VJFET includes a trench structure 102 extending into a semiconductor body 106, e.g. SiC semiconductor body, from first surface 108 of the semiconductor body 106. The trench structure 102 is laterally confined by mesa regions 1041, 1042 along a first lateral direction x1.

Each of the mesa regions 1041, 1042 includes an n-doped mesa channel region 110. A p-doped gate region 112 adjoins opposite sidewalls 1021, 1022 of the trench structure 102. The p-doped gate region 112 further adjoins a bottom side 1023 of the trench structure 102.

A silicon layer 114 adjoins the gate region 112 at the bottom side 1023 of the trench structure 102. A first thickness t1 of the gate region 112 at the bottom side 1023 of the trench structure 102 is larger than a second thickness t2 of the gate region 112 at each of the opposite sidewalls 1021, 1022 of the trench structure 102. For example, the first thickness t1 of the gate region 112 at a center of the bottom side 1023 of the trench structure 102 may be at least 50 % larger than the second thickness t2 of the gate region 112 at a vertical reference level vref defined by a center of a vertical extension of the silicon layer 114. A maximum doping concentration of a vertical doping concentration profile of the gate region 112 at the center of the bottom side 1023 of the trench structure 102 may be from one to three orders of magnitude larger than a maximum doping concentration of a lateral doping concentration profile of the gate region 112 at the vertical reference level vref. This relation may be adjusted by suitable process parameters when forming the gate region 112, e.g. by an ion implantation dose through the bottom side 1023 that is larger than the ion implantation dose through the opposite sidewalls 1021, 1022.

A junction between the gate region 112 and the silicon layer 114 at the bottom side 1023 of the trench structure 102 is a rectifying heterojunction, e.g. a rectifying Si/SiC heterojunction.

The bottom side 1023 of the trench structure 102 has a third vertical distance d3 to the first surface 108. A top side of the silicon layer 114 has a fourth vertical distance d4 to the first surface. For example, the fourth vertical distance d4 may have a value in a range from 20 % to 99 % of the third vertical distance d3.

A dielectric layer 116 is arranged over the silicon layer 114. The dielectric layer 116 extends, along a vertical direction y, from below the first surface 108 toward, or up to or over the first surface 108.

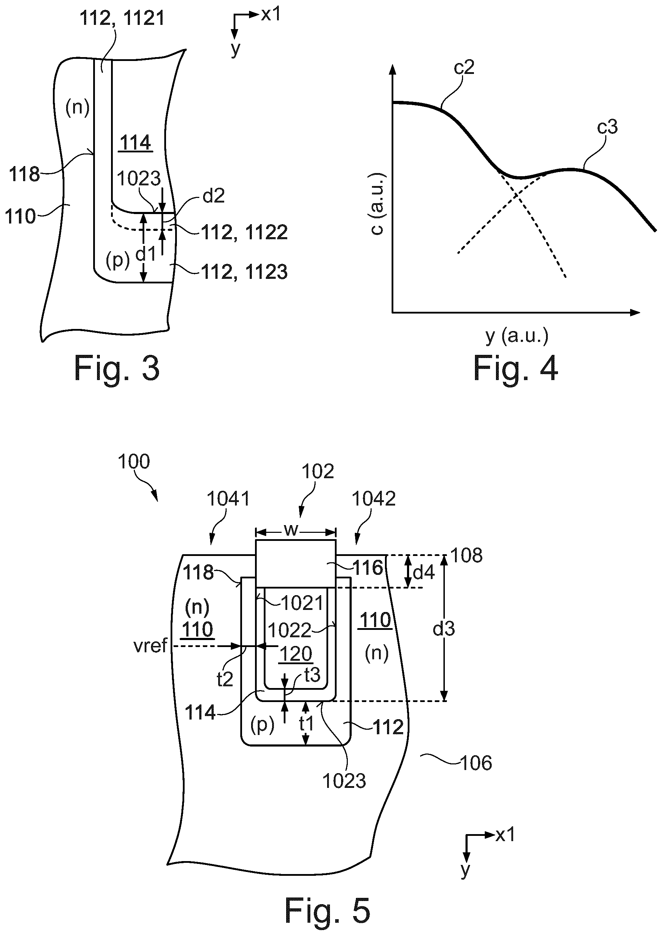

Referring to the schematic cross-sectional view of Fig. 3, a configuration example of the gate region 11 is described in more detail. In the example illustrated in Fig. 3, the gate region 112 is formed by at least three overlapping gate sub-regions 1121, 1122, 1123. The first gate sub-region 1121 adjoins at least part of the sidewall 1021, and likewise the opposite sidewall 1022 not illustrated in Fig. 3, of the trench structure 102. The second gate sub-region 1122 adjoins the bottom side 1023 of the trench structure 102. The third gate sub-region 1123 adjoins to a bottom side of the second gate sub-region 1122.

Referring to the exemplary graph of Fig. 4 illustrating a profile of doping concentration c of the gate region 112 along the vertical direction y starting at the bottom side 1023 of the trench structure 102, a vertical doping concentration profile c2 defining the second gate sub-region 1122 and a vertical doping concentration profile c3 defining the third gate sub-region 1123 partly overlap.

A further configuration example of a VJFET 100 is illustrated in the schematic cross-sectional view of Fig. 5.

The configuration example of the VJFET 100 illustrated in Fig. 5 differs from the configuration example illustrated in Fig. 1 by the layout of the silicon layer 114, and by a metal layer 120 arranged between the dielectric layer 116 and the silicon layer 114. The silicon layer 114 lines a part of the opposite sidewalls 1021, 1022 of the trench structure 102 as well as the bottom side 1023 of the trench structure 102. A thickness t3 of the silicon layer 114 is smaller than 30 % of a width w of the trench structure 102 at the first surface 108.

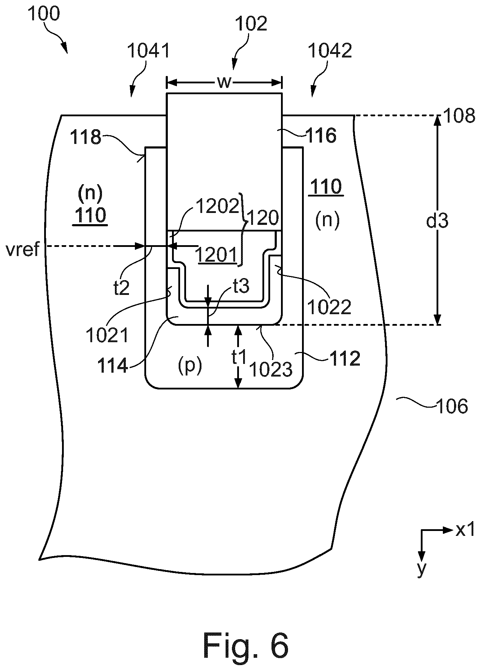

A further configuration example of a VJFET 100 is illustrated in the schematic cross-sectional view of Fig. 6.

The configuration example of the VJFET 100 illustrated in Fig. 6 differs from the configuration example illustrated in Fig. 5 in that the silicon layer 114 lines a smaller part of the opposite sidewalls 1021, 1022 of the trench structure 102 compared to the example illustrated in Fig. 5. Moreover, the metal layer 120 is exemplified by a combination of a first metal sub-layer 1201, e.g. a barrier layer including TiN or Ti/TiN, and a second metal sub-layer 1202, e.g. a W or Al layer. Apart from the specific numbers of sub-layers and materials mentioned with respect to the metal layer 120 illustrated in Fig. 5 and 6, other numbers of sub-layers and material combinations may be chosen.

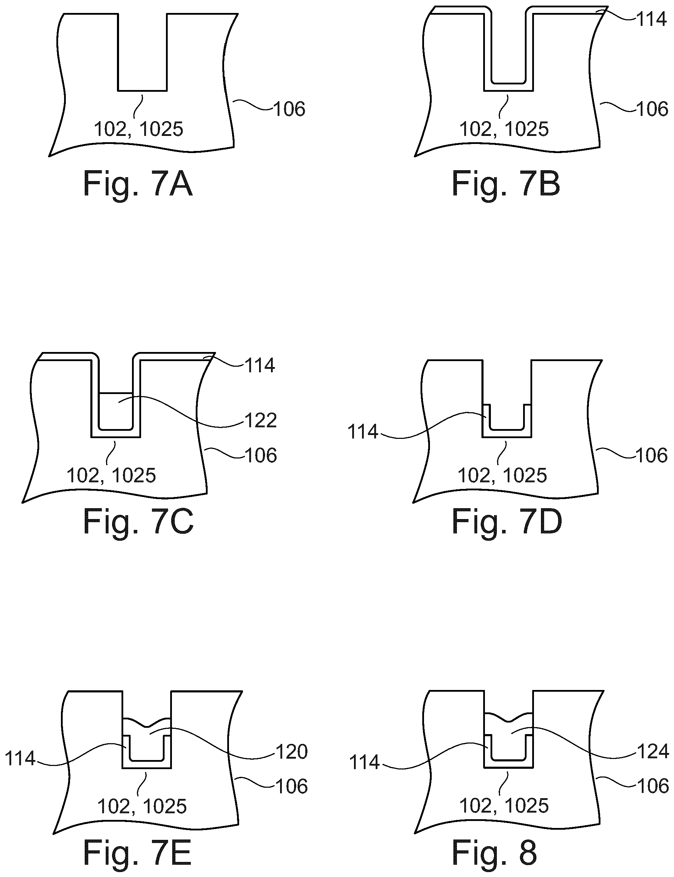

The schematic cross-sectional views of Figs. 7A to 7E illustrate exemplary process features of forming the trench structure 102 or part thereof.

Referring to Fig. 7A, a trench 1025 of the trench structure 102 is formed into the semiconductor body 106, e.g. by an etch process using an etch mask. A wet chemical cleaning of the exposed surface may follow.

Referring to Fig. 7B, a silicon layer 114, e.g. an amorphous silicon layer or a polycrystalline silicon layer, is formed, e.g. by a deposition process. The silicon layer 114 may be undoped or doped in-situ. The silicon layer 114 may act as a protective layer as well as a contact formation layer at the bottom side of the trench structure 102. In some examples, dopants, e.g. Al, may be further introduced into the silicon layer 114 by one or more ion implantation processes. An annealing process may follow for forming a liquid phase, e.g. SiAl phase, that may react with the SiC surface, e.g. similar to a soldering process.

Referring to Fig. 7C, a plug 122, e.g. a resist plug, is formed in the trench 1025, e.g. by a resist coating and etch back process.

Referring to Fig. 7D, the silicon layer 114 is etched back or recessed using the plug 122 as a protective cover. A U-shaped silicon layer 114 remains. The U-shaped silicon layer 114 may be optionally encapsulated with a cover such as a TEOS cover for protecting the U-shaped silicon layer 114, e.g. against auto-doping, outgasing effects, avoidance of oxide formation and etching of the U-shaped silicon layer 114 in view of further processing applied to the semiconductor body 106. The U-shaped silicon layer 114 may be optionally treated with additional annealing processes.

Referring to Fig. 7E, after removal of the optional cover, e.g. by wet chemical processing, a metal layer 120 is formed on the silicon layer 114. The metal layer 120 may include, similar to the illustration in Fig. 6, a combination of a first metal sub-layer, e.g. a barrier layer including Ti or Ti/TiN, and a second metal sub-layer, e.g. a W or Al layer. Other numbers of sub-layers and material combinations may be chosen for the metal 120, for example.

The schematic cross-sectional view of Fig. 8 illustrates a further process feature that may be carried out after the processing the semiconductor body 106 up to the illustration in Fig. 7D. Referring to Fig. 8, a highly doped semiconductor layer 124, e.g. a polycrystalline silicon layer, is formed instead of, or in addition to, the metal layer 120 illustrated in Fig. 7E. The highly doped semiconductor layer 124 may be formed by a layer deposition process of undoped or in-situ doped semiconductor material. For example, after the layer deposition process, the doping concentration in the highly doped semiconductor layer 124 may be further adjusted by one or more ion implantation processes of dopants into the highly doped semiconductor layer 124. An annealing process may follow. The deposited highly doped semiconductor layer 124 is then recessed resulting in the illustration of Fig. 8.

In the configuration examples of VJFETs described above, the silicon layer may be omitted and the metal in the trench structure may adjoin the gate region, for example.

The aspects and features mentioned and described together with one or more of the previously described examples and figures, may as well be combined with one or more of the other examples in order to replace a like feature of the other example or in order to additionally introduce the feature to the other example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A vertical junction field effect transistor, VJFET (100), comprising:
a trench structure (102) laterally arranged between mesa regions (1041, 1042) along a first lateral direction (x1), the trench structure (102) extending into a semiconductor body (106) from a first surface (108) of the semiconductor body (106), wherein each of the mesa regions (1041, 1042) includes a mesa channel region (110) of a first conductivity type;
a gate region (112) of a second conductivity type, wherein the gate region (112) adjoins at least part of opposite sidewalls (1021, 1022) of the trench structure (102) and to a bottom side (1023) of the trench structure (102);
a silicon layer (114) adjoining the gate region (112) at the bottom side (1023) of the trench structure (102); and wherein
a first thickness (t1) of the gate region at the bottom side (1023) of the trench structure (102) is larger than a second thickness (t2) of the gate region (112) at each of the opposite sidewalls (1021, 1022) of the trench structure.

2. The VJFET (100) of the preceding claim, wherein a junction between the gate region (112) and the silicon layer (114) at the bottom side (1023) of the trench structure (102) is a rectifying heterojunction.

3. The VJFET (100) of any of the preceding claims, wherein a maximum doping concentration of the silicon layer (114) has a value in a range from 10¹⁶ cm⁻³ to 10²² cm⁻³.

4. The VJFET (100) of any of the preceding claims, wherein the first thickness (t1) of the gate region (112) at a center of the bottom side (1023) of the trench structure (102) is at least 50 % larger than the second thickness (t2) of the gate region (112) at a vertical reference level (vref) defined by a center of a vertical extension of the silicon layer (114).

5. The VJFET (100) of any of the preceding claims, wherein a maximum doping concentration of a vertical doping concentration profile of the gate region (112) at the center of the bottom side (1023) of the trench structure (102) is from one to three orders of magnitude larger than a maximum doping concentration of a lateral doping concentration profile of the gate region (112) at the vertical reference level (vref).

6. The VJFET (100) of any of the preceding claims, wherein the gate region (112) is formed by at least three overlapping gate sub-regions (1121, 1122, 1123), a first gate sub-region (1121) adjoining at least part of the opposite sidewalls (1021, 1022) of the trench structure (102), a second gate sub-region (1122) adjoining the bottom side (1023) of the trench structure (102), and a third gate sub-region (1123) adjoining a bottom side of the second gate sub-region (1122), and wherein a vertical doping concentration profile (c2) defining the second gate sub-region (1122) and a vertical doping concentration profile (c3) defining the third gate sub-region (1123) partly overlap.

7. The VJFET (100) of the preceding claim, wherein a first vertical distance (d1) from a bottom side of the third gate sub-region (1123) to the bottom side (1023) of the trench structure (102) is by a factor ranging from 2 to 20 larger than a second vertical distance (d2) from a bottom side of the second gate region (1122) to the bottom side (1023) of the trench structure (102).

8. The VJFET (100) of any of the two preceding claims, wherein a maximum doping concentration of a vertical doping concentration profile (c2) of the second gate sub-region (1122) at the center of the bottom side (1023) of the trench structure (102) is from one to three orders of magnitude larger than a maximum doping concentration of a vertical doping concentration profile (c3) of the third gate sub-region (1123) at the center of the bottom side (1023) of the trench structure (102).

9. The VJFET (100) of the preceding claim, wherein a bottom side of the trench structure (102) has a third vertical distance (d3) to the first surface (108), and wherein a top side of the silicon layer (114) has a fourth vertical distance (d4) to the first surface, the fourth vertical distance (d4) having a value in a range from 20 % to 99 % of the third vertical distance (d3).

10. The VJFET (100) of any of the preceding claims, wherein the trench structure (102) further includes a dielectric layer (116) over the silicon layer (114), and wherein the dielectric layer (116) extends, along a vertical direction (y), from below the first surface (108) toward, or up to or over the first surface (108).

11. The VJFET (100) of the preceding claim, wherein the trench structure (102) further includes at least one metal layer arranged between the dielectric layer (116) and the silicon layer (114).

12. The VJFET (100) of any of the preceding claims, wherein the silicon layer (114) lines a bottom side of the trench structure (102) and at least part of the opposite sidewalls (1021, 1022) of the trench structure (102), a thickness (t3) of the silicon layer (114) being smaller than 30 % of a width (w) of the trench structure (102) at the first surface (108).

13. The VJFET (100) of any of the preceding claims, wherein a pn junction (118) between the gate region (112) and the mesa channel region (110) adjoins the trench structure (102) at a smaller vertical distance to the first surface (108) than the third vertical distance (d3).

14. A method of manufacturing a vertical junction field effect transistor, VJFET (100), the method comprising:
forming a trench structure (102) laterally arranged between mesa regions (1041, 1042) along a first lateral direction (x1), the trench structure (102) extending into a semiconductor body (106) from a first surface (108) of the semiconductor body (106), wherein each of the mesa regions (1041, 1042) includes a mesa channel region (110) of a first conductivity type;
forming a gate region (112) of a second conductivity type, wherein the gate region (112) adjoins to at least part of opposite sidewalls (1021, 1022) of the trench structure (102) and to a bottom side (1023) of the trench structure (102);
forming a silicon layer (114) adjoining the gate region (112) at the bottom side (1023) of the trench structure (102); and wherein
a first thickness (t1) of the gate region at the bottom side (1023) of the trench structure (102) is larger than a second thickness (t2) of the gate region (112) at each of the opposite sidewalls (1021, 1022) of the trench structure.

15. The method of the preceding claim, wherein the gate region (112) is formed by at least three overlapping gate sub-regions (1121, 1122, 1123), a first gate sub-region (1121) adjoining at least part of the opposite sidewalls (1021, 1022) of the trench structure (102), a second gate sub-region (1122) adjoining the bottom side (1023) of the trench structure (102), and a third gate sub-region (1123) adjoining a bottom side of the second gate sub-region (1122), and wherein forming the first gate sub-region (1221) includes at least one tilted ion implantation process of dopants through a sidewall of a gate trench, forming the second gate sub-region (1122) includes at least one ion implantation process of dopants through a bottom side of the gate trench, and forming the third gate sub-region (1122) includes at least ion implantation process of dopants through the bottom side of the gate trench.
